# EUROPEAN PATENT APPLICATION

(11) **EP 4 737 730 A1**
(43) Date of publication of application: **06.05.2026**
(21) Application number: 25169401.4
(22) Date of filing: 09.04.2025
(51) Int. Cl.: F04D 3/02, F04D 13/06, F04D 29/041, F04D 29/043, F04D 29/046, F04D 29/049, F04D 29/18, F04D 29/20, F04D 29/52, F04D 29/58, F04D 29/64, F16C 35/077, H05K 7/20, H02K 5/173

(54) **MICRO-AXIAL PUMP WITH PRESS-FIT IMPELLER**

(30) Priority: 29.10.2024 US 202418930262
(71) Applicant: Hewlett Packard Enterprise Development LP, Spring, TX 77389 (US)
(72) Inventor: LESTER, Laura, Spring, 77382 (US); KUFAHL, Benjamin John, 50733 Cologne (DE); LUNSMAN, Harvey John, Chippewa Falls, 54729 (US)
(74) Representative: Marks & Clerk LLP

(57) **Abstract**

An axial pump for delivering liquid coolant to cool an electronic device comprises a conduit, an impeller in the conduit, a shaft, a rotor, and a motor stator. The conduit defines a flow path from an inlet of the conduit to an outlet of the conduit. The rotor is disposed in a hollow interior of the impeller and comprises magnetic portions, a front bearing housing, and a rear bearing housing. The front and rear bearing housing comprising bearings rotatably coupling the rotor to the shaft. The motor stator is configured to drive rotation of the rotor about the shaft, with the impeller rotating along with the rotor about an axis of rotation extending parallel to the flow path. The rotor is coupled to the impeller by a press-fit attachment of the front bearing housing to the impeller.

## Description

### INTRODUCTION

Some information processing systems utilize liquid cooling techniques to remove heat from the system. In these systems, a liquid coolant is circulated in a loop through the information processing devices (e.g., servers, networking devices, etc.) of the system, and heat generating components thereof (e.g., processors) are thermally coupled (e.g., via cold plates) to the liquid coolant so that the liquid coolant absorbs heat from these components. As the now-heated coolant exits the information processing devices, it carries the heat to a cooling device (such as a heat exchanger) which cools the liquid back to a desired operating temperature, whereupon the cooled liquid is circulated through the loop once again, extracting more heat from the information processing devices. Such a liquid cooling loop uses one or more pumps to drive the circulation of the liquid through the loop. Often, these pumps are disposed in a so-called coolant distribution unit (CDU) which provides a centralized pumping unit which circulates the liquid collectively through multiple information processing devices (e.g., an entire rack, or multiple racks, of such devices). These pumps are usually very large, with the CDU often taking up a substantial portion of a rack, or in some cases a full rack.

### BRIEF DESCRIPTION OF THE DRAWINGS

The present disclosure can be understood from the following detailed description, either alone or together with the accompanying drawings. The drawings are included to provide a further understanding of the present disclosure and are incorporated in and constitute a part of this specification. The drawings illustrate one or more examples of the present teachings and together with the description explain certain principles and operations. In the drawings:
FIG. 1 is a schematic diagram illustrating a top view of an example pump.
FIG. 2 is a perspective view of another example pump.
FIG. 3 is an exploded view of the pump of FIG. 2.
FIG. 4 is an exploded perspective view of an impeller chamber subassembly of the pump of FIG. 2, including a perspective sectional view of a portion of the impeller chamber subassembly with the section taken along the plane 4-4in FIG. 2.
FIG. 5 is an exploded perspective view of a rotor and shaft of the pump of FIG. 2.
FIG. 6 is a partially exploded perspective view of the rotor and shaft of FIG. 5 in a partially assembled state.
FIG. 7 is a perspective view of the rotor and shaft of FIG. 5 in an assembled state.
FIG. 8 is a front view of a front bearing housing of a rotor of the pump of FIG. 2.
FIG. 9 is a front perspective view of the front bearing housing of FIG. 8.
FIG. 10 is a rear perspective view of the front bearing housing of FIG. 8.
FIG. 11 is a rear perspective view of a rear bearing housing of a rotor of the pump of FIG. 2.
FIG. 12 is a rear perspective view of the rear bearing housing of FIG. 11 with a rear radial bearing installed.
FIG. 13 is a rear perspective view of the rear bearing housing of FIG. 11 with a rear thrust bearing installed.
FIG. 14 is a rear perspective view of the rear bearing housing of FIG. 11 with a retainer installed.
FIG. 15 is a perspective cross-section of the impeller/rotor subassembly of the pump of FIG. 2 in a partially assembled state, with the section taken along the plane 4-4 indicated in FIG. 2.
FIG. 16 is a cross-section of the impeller/rotor subassembly of the pump of FIG. 2 in an assembled state, with the section taken along the plane 4-4 indicated in FIG. 2.
FIG. 17 is a cross-section of the pump of FIG. 2, with the section taken along the
FIG. 18 is a schematic diagram of an information processing system with a pump.

### DETAILED DESCRIPTION

In some cases, it may be desired to utilize relatively small pumps in liquid cooling loops, rather than the commonly used large CDU pumps. One advantage of using smaller pumps for liquid cooling information processing systems is that the smaller pumps can be more efficient than the larger pumps, in terms of the amount of liquid they can move per unit of energy spent. The smaller pumps can also fit in places that the large pumps will not, which opens opportunities for system designers to arrange their systems in new and potentially more efficient ways which would not have otherwise been possible. For example, smaller pumps can allow for a distributed pumping architecture to be utilized, in which each information processing device is provided with one or more small pumps localized to the device (e.g., disposed within, or adjacent to, the chassis of the device) to control the circulation of fluid locally through that device in an individualized manner, rather than using a single large centralized pumping unit to control the flow of fluid collectively through the devices. This distributed approach can improve efficiency and performance of the liquid cooling loop, potentially reducing power usage and noise while also delivering more coolant flow (and hence better cooling). In addition, this may also facilitate greater modularity and scalability of the system, as the pumping capacity of the system naturally scales along with the demand for cooling, since each new device added to the system brings its own pump(s) with it.

While having smaller pumps can in theory be advantageous, realizing these advantages can be challenging with existing pump technologies. Many existing pumps that can produce the needed levels of pressure and liquid flow rates for liquid cooling an information processing device are simply too large, or are too awkwardly shaped, to fit well within the densely packed environment of an information processing device. Other pumps (such as artificial heart pumps) may be small enough to fit in a space-constrained information processing system, but these generally have inadequate pumping characteristics (e.g., insufficient pressure, insufficient flow rates, poor efficiency, etc.) for the liquid cooling context. In other words, it is challenging to find pumps which both have a suitable small form factor and which have desired pumping characteristics. Thus, to meet this unique combination of challenges, specialized pumps are being developed, such as the micro-axial pumps described in US Patent No. 11015608 B2, the contents of which are incorporated herein by reference in their entirety. An axial pump has an impeller (the part that moves within the liquid to drive the flow) that spins along an axis that is coaxial with a flow direction of the liquid, in contrast to centrifugal pumps which have impellers that spin along an axis transverse to the flow direction of the liquid. The axial arrangement, together with various other improvements, allows for the micro-axial pumps to have a form factor which is both extremely small and conveniently shaped (e.g., rectangular in cross-section), while still providing the same or better effectiveness and efficiency as larger pumps. For example, some micro-axial pumps under development may be similar in size and shape to a deck of cards while being capable of providing flow rates of such as 4 GPM at 4PSID (i.e., with a 4 PSI pressure drop), 2 GPM at 11.5 PSID, or 1 GPM at 13.9 PSID.

However, the small size and other structural aspects of such micro-axial pumps can pose a variety of technical challenges, particularly when it comes to the manufacture and assembly of such pumps. One such challenge arises in relation to assembling an impeller of the pump to a rotor of the pump to form an impeller/rotor sub-assembly. The impeller has a hollow interior in which the rotor of the pump is housed. The rotor includes a group of magnets which are driven to rotate by magnetic forces generated by the pump, as well as bearings which rotatably couple the rotor to a shaft. The rotor needs to be affixed to the impeller so that when the rotor is driven to rotate, the impeller is forced to rotate along with it, thereby moving liquid through the pump.

However, it can be difficult to couple the impeller to the rotor in an efficient and reliable manner. One approach which has been considered is using epoxy or other bonding agents (adhesives) to bond the outer surfaces of the rotor to the inner surfaces of the impeller inside the hollow interior thereof. But using this approach there is a risk that the epoxy or other agent will leak into the bearings, gluing them up or impairing their performance. In addition, the mass of the epoxy may be unevenly distributed around the rotor which can upset the balance of the rotor leading to wobble which can reduce pump efficiency, generate more noise, and/or lead to premature failure. To reduce these risks, one may attempt to utilize only small and precisely controlled amounts of epoxy deposited at precisely controlled positions, but this may require the use of high-accuracy epoxy dispensing equipment. This equipment can be very costly and also complicated and time-consuming to operate, driving up the costs of the pumps and creating a bottleneck in the manufacturing process. And even with this expensive and complicated equipment, there is still some variability in epoxy amount and position, and thus the concerns noted above may not be fully eliminated. Furthermore, the strength of the bond created by the bonding agent and the compatibility of the bonding agent with the other materials and with the liquid of the cooling loop may be uncertain, and thus time-consuming investigations may be needed to find and validate appropriate materials.

Accordingly, to address the problems noted above (among other things), the present disclosure provides micro-axial pumps in which the impeller and the rotor are configured to be connected together by press fitting, in some cases without requiring any epoxy or other bonding agents to bond the two parts together. In some examples, the rotor comprises a forward bearing housing which is inserted axially into the impeller until ultimately engaging a forward engagement portion of the impeller and being press-fitted into a bore of the forward engagement portion. The forward bearing housing and forward engagement portion of the impeller may be configured to have an interference fit, meaning that the outer diameter of the forward bearing housing at its wideset point(s) exceeds the inner diameter of the bore of the forward engagement portion of the impeller. As a result of this interference fit, when the impeller and rotor are pressed together (e.g., using a hydraulic press), the bearing housing "bites" into the forward engagement portion of the impeller, displacing material of the impeller inner surface. This press-fit connection mechanically attaches the impeller to the bearing housing by virtue of creating a high friction interface between the bearing housing and the impeller which strongly resists axial motion of either part relative to the other.

In some examples, the outer surface of the forward bearing housing may include knurls which protrude radially and which engage with the forward engagement portion as part of the press-fit connection. The knurls may have diameters that exceed the bore diameter of the impeller's engagement portion. Thus, the knurls bite into (displace portions of) the inner surface of the engagement portion during the press-fitting and create a strong friction interface. Furthermore, the portions of the bearing housing located between the knurls may have smaller diameters, in some cases equal to or less than the bore diameter of the engagement portion of the impeller, and therefore less force may be needed during the press fitting process and the risk of damaging the impeller may be reduced, as compared to if the bearing housing had a uniform diameter which exceeded the bore diameter of the engagement portion of the impeller. In some examples, the knurls may have a barbed configuration in which they have a sloped lead-in surface followed by a cutback (notch). The sloped lead-in surface makes it easier to insert the bearing housing in the forward direction into the bore of the engagement portion of the impeller, whereas the cutback provides a relatively sharp trailing edge which can bite into the inner surface of the impeller and thereby strongly resist rearward retraction of the bearing housing from the impeller.

In some examples, the press-fit connection between the impeller and the rotor can allow for chemical bonding agents (e.g., epoxy) to be omitted, and thus there is no risk of inadvertently gluing up the bearings or introducing uneven mass distributions. Moreover, a press-fitting operation is less complicated and can be performed more quickly than the precision epoxy deposition, and moreover the equipment needed for the press-fitting is much less expensive than the equipment that would be needed for the precision epoxy deposition. Furthermore, with press-fitting there is no risk of chemical incompatibility with the liquid coolant or other materials. Press-fitting also can produce a more repeatable and consistent connection with less potential for failure.

Turning now to the figures, various devices, systems, and methods in accordance with nonlimiting aspects of the present disclosure will be described.

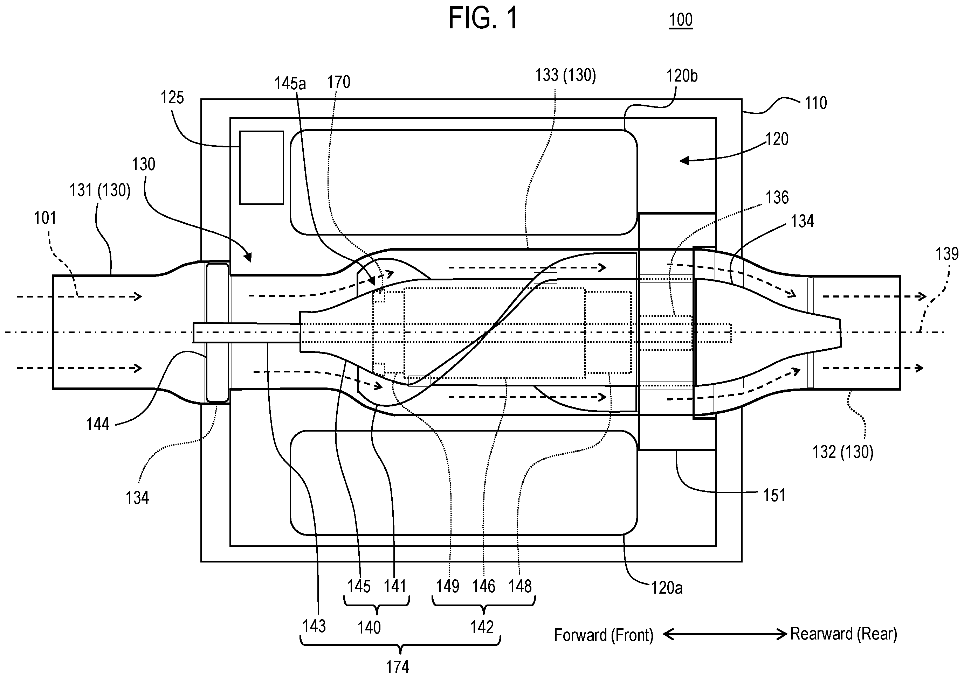

FIG. 1 is a schematic diagram conceptually illustrating a pump 100. FIG. 1 shows the pump 100 from a perspective above the pump and illustrates general positional and functional relationships between components, as described below, but the diagram is schematic in nature and is not intended to illustrate specific shapes, dimensions, or other structural details accurately or to scale. It should be understood that implementations of the pump 100 can vary from one another in various aspects. Some implementations of the pump 100 may have different numbers and arrangements of the illustrated components. Some implementations of the pump 100 may include other parts that are not illustrated in FIG. 1. Some implementations of the pump 100 may omit one or more of the parts that are illustrated in FIG. 1.

As shown in FIG. 1, the pump 100 comprises a housing 110, a motor stator 120 (also "stator 120"), control circuitry 125, a conduit 130 defining a liquid flow path 101, and an impeller/rotor sub-assembly 174 comprising an impeller 140, a rotor 142, and a shaft 143. The housing 110 and conduit 130 are shown as transparent to allow visibility of the other components. In addition, some parts (or portions of parts) which are covered by (e.g., contained within) other parts are shown in dotted lines; this is done to make it easier to visually distinguish the covered parts from the covering parts. The components of the pump 100 will be described in greater detail below.

The housing 110 comprises one or more walls or other support structures that support and at least partially enclose or house some of the other components of the pump 100. The housing 110 may be a single part or made from multiple parts assembled together. In some examples, the parts of the housing 110 may also be coupled to and/or form an integral part of the other parts of the pump 100. For example, portions of the conduit 130 may also form parts of the housing 110.

The motor stator 120 is configured to receive electrical power from the control circuitry 125 and in response generate alternating magnetic fields that interact with the rotor 142 of the impeller/rotor sub-assembly 174 to cause the rotor 142 (and hence the impeller 140 coupled thereto) to rotate about a rotation axis thereof, depicted in FIG. 1 as axis 139. The motor stator 120 may comprise wire windings or other electrically conductive materials to generate the magnetic fields and/or magnetically susceptible materials to transfer and distribute the generated fields around the impeller/rotor sub-assembly 174 in a desired pattern. In some examples, the motor stator 120 comprises two portions: a first stator portion 120a and a second stator portion 120b, as shown in FIG. 1. These portions 120a and 120b are arranged on opposite lateral sides of the conduit 130. US 11015608 B2 describes example stators that are split into two portions, and these, for example, may be used as the motor stator 120.

The control circuitry 125 is configured to control operations of the pump 100. In some examples the control circuitry 125 comprises a printed circuit assembly (PCA) with various electronic components formed therein and/or mounted thereon, and/or additional components external to the PCA. In some examples the control circuitry 125 includes logic to drive operations of the pump 100. For example, control circuitry 125 may include a microcontroller. As another example, the control circuitry 125 may include discrete logic circuits (digital or analog), in addition to or instead of a microcontroller. The control circuitry 125 may also include sensors, such as temperature sensors, electrical power usage sensors, moisture sensors (e.g., for leak detection), magnetic field (e.g., Hall effect) sensors, or other sensors. The control circuitry 125 may also include power delivery components, such as transistors or other switches (e.g., relays), capacitors, diodes, etc. In some examples, the control circuitry 125 may include communications components for communicating with outside devices such as a system controller, baseboard management controller (BMC), rack controller, etc., for example via the cables (not illustrated) coupled to the pump 100 and/or wirelessly (via, e.g., Bluetooth, WiFi, etc.). The control circuitry 125 may be electrically coupled to the motor stator 120 to provide electrical signals thereto to drive the operation of the motor stator 120. The control circuitry 125 may be coupled to an outside power source and/or an outside controller via wires or cables (not illustrated).

The conduit 130 comprises walls that partially enclose a volume and define the liquid flow path 101 through that volume, with the liquid flow path 101 being the path along which liquid coolant (e.g., water or other coolants) flows as it traverses the pump 100. The conduit 130 comprises a pump inlet portion 131 (also "inlet 131") having a first opening into the enclosed volume of the conduit 130, a pump outlet portion 132 (also "outlet 132") having a second opening into the enclosed volume of the conduit 130, and an impeller chamber portion 133 between the other two portions 131/132. The impeller chamber portion 133 houses the impeller 140 and is fluidically coupled to the inlet 131 and outlet 132. The pump inlet portion 131 and pump outlet portion 132 may comprise structures for fluidically coupling the pump with coolant lines of a liquid cooling loop, such as hose barbs, fittings, quick connect couplings, and/or other liquid coupling mechanisms as would be familiar to those of ordinary skill in the art. The conduit 130 may be liquid tight, sealing the interior volume from an exterior environment, other than at openings in the inlet 131 and outlet 132 that allow the enclosed interior volume to be fluidically coupled to the exterior environment (e.g., to coolant lines of a liquid cooling loop). In some examples, the inlet 131 and outlet 132 may extend outside of the housing 110 of the pump 100. In some examples, the impeller chamber portion 133 is contained within the housing 110.

The conduit 130 has a central longitudinal axis. This axis is coaxial with various other axes of other parts of the pump 100, including a rotational axis of the rotor 142, a rotational axis of the impeller 140 (described below), and a central longitudinal axis of a shaft 143, and therefore all of these axes are depicted in FIG. 1 by the same axis 139. Accordingly, all of these co-axial axes may hereinafter be referred to interchangeably as the axis 139. Liquid flowing through the conduit 130 flows, as whole, along directions parallel to the axis 139, as indicated by the dashed arrows representing the flow path 101 in FIG. 1. Note that the liquid may also spiral circumferentially around the axis 139 (in addition to moving axially) while traversing certain portions of the flow path 101 (e.g., while passing the impeller 140), but the bulk or average motion of the liquid as a whole in traversing the conduit 130 is along directions parallel to the axis 139. The liquid flow path 101 is shown in FIG. 1 to illustrate how the pump 100 is configured to flow liquid when deployed, but note that the liquid is not necessarily part of the pump 100 and is not necessarily present in all states of the pump 100. For example, prior to being deployed in a liquid cooling loop, there might be no liquid in the pump 100.

As mentioned above, the impeller/rotor sub-assembly 174 comprises an impeller 140 and a rotor 142 attached together and disposed within the conduit 130. The impeller/rotor sub-assembly 174 also comprises a shaft 143 to which rotor 142 is rotatably attached such that the rotor 142, and the impeller 140 coupled thereto, can rotate about the shaft 143. A rotation axis of the rotor 142, a rotation axis of the impeller 140, a longitudinal axis of the shaft 143, and a longitudinal axis of the conduit 130, are all coaxial, as mentioned above. The shaft 143 is fixedly attached to the housing 110, and thus when the rotor 142 and impeller 140 rotate about the shaft 143, they are also rotating relative to the housing 110. The impeller 140 and the rotor 142 will be described in greater detail in turn below.

The impeller 140 is housed within the conduit 130, specifically in the impeller chamber 133 thereof. The impeller 140 is configured to, when rotated about the axis 139, drive liquid to flow along the flow path 101 through the conduit 130. The impeller 140 comprises an impeller body 145 and blades 141 that protrude radially from and spiral along/around the impeller body 145. References to the blades 141 spiraling along or around the impeller body 145 mean that the blades 145 extend along paths that axially traverse the impeller body 145 while simultaneously circling circumferentially around the impeller body 145 through at least portions of the path; for example, the paths could be helical. The blades 141 are configured to force the liquid axially along the flow path 101 through the conduit 130 as the impeller 140 rotates.

The impeller body 145 is hollow (i.e., has an internal bore therethrough) and the rotor 142 is at least partially contained within the hollow interior of the impeller 140. Specifically, the impeller body 145 may have a shape roughly of a hollow cylinder with openings at both ends and with one end being tapered/rounded. The shaft 143 also extends through the internal bore of the impeller body 145.

In some examples, the impeller body 145 and the impeller blades 141 are integrally connected, meaning they are formed together as two parts of the same monolithic body. The impeller body 145 may be formed from any solid material which can be formed into the desired shape. For example, the impeller body 145 may be formed from various plastics, which can be formed into the desired shape by injection molding, additive manufacturing (e.g., 3D printing), or other techniques. As another example, the impeller body 145 may be formed from various metals, which can be formed into the desired shape by casting, additive manufacturing (e.g., 3D printing), or other techniques.

The rotor 142 comprises magnetic portions 146, a rear bearing housing 148, and a front bearing housing 149. The rotor 142 is configured to rotate in response to the magnetic fields generated by the motor stator 120, thus causing the impeller 140 attached thereto to also rotate. Specifically, the magnetic portions 146 of the rotor 142 are arranged to interact with the magnetic fields generated by the motor stator 120 to produce rotation of the rotor 142. Thus, the rotor 142 and the motor stator 120 may together form an electromagnetic motor. The magnetic portions 146 may comprise permanent magnets and/or magnetically attractable (e.g., ferromagnetic) materials (e.g., iron, steel, etc.) which are capable of interacting with (e.g., being attracted or repelled by) the generated magnetic fields. In some examples, the magnetic portions 146 comprise multiple permanent magnets which are distributed circumferentially around the axis 139 and arranged with alternating polarities.

The rotor 142 also comprises a rear bearing housing 148 and a front bearing housing 149. The rear bearing housing 148 is disposed rearward (downstream) of the magnetic portions 146 and the front bearing housing 148 is disposed forward (upstream) of the magnetic portions 146. The rear and front bearing housings 148 contain various bearings to bear against the shaft 143 and to rotatably attach the rotor 142 to the shaft 143. These bearings may include radial bearings and, in some examples, thrust bearings. As would be familiar to those of ordinary skill in the art, radial bearings are configured to primarily bear radial forces, facilitating rotation of the rotor 142 about the shaft 143, whereas thrust bearings are configured to primarily bear axial forces, resisting axial motion of the rotor 142 along the shaft 143. In addition, the front bearing housing 148 has a rigid structure configured to be press-fitted into a press-fitting engagement portion 145a of the impeller body 145, as described below.

The rotor 142 is configured to be attached to the impeller 140 in the following manner. The rotor 142 is first inserted at least partially into the internal bore of the impeller body 145 by passing the front bearing housing 149 in a forward direction through a rear opening of the bore and advancing the rotor 142 forward until the front bearing housing 148 comes into contact with the press-fit engagement portion 145a of the impeller body 145. Thereafter, forces may be applied to press the impeller body 145 and the rotor 142 together until the front bearing housing 148 is press-fitted into the press-fit engagement portion 145a of the impeller body 145. That is, the impeller body 145 may be pressed rearward while the rotor 142 is pressed forward or held stationary, or the rotor 142 may be pressed forwards while the impeller body 145 is pressed rearward or held stationary. For example, a hydraulic press or other press-fitting equipment may be used to apply the forces to achieve the press fitting. During the press fitting, the front bearing housing 148 is received in a cavity defined by the press-fitting engagement portion 145a, with this cavity corresponding to a portion of the internal bore of the impeller 140. The front bearing housing 148 has a maximum diameter at its widest point(s) which exceeds the diameter of this cavity. Thus, there is an interference fit between the front bearing housing 148 and the press-fitting engagement portion 145a, and as the front bearing housing 148 is pressed into the cavity of the press-fitting engagement portion 145a the outward facing surfaces of the front bearing housing 148 will engage (slide against, displace, scratch, and/or deform) the inward-facing surfaces of the press-fitting engagement portion 145a. Thus, when the press-fitting is complete, a strong friction attachment is formed between the front bearing housing 149 and the impeller body 145.

In some examples, the front bearing housing 148 comprises knurls 170. The knurls 170 protrude radially and engage with the press-engagement portion 145a as part of the press-fit connection. The knurls 170 may have diameters that exceed the bore diameter of the engagement portion 145a. Thus, the knurls 170 bite into (displace portions of) the inner surface of the engagement portion 145a during the press-fitting and create a strong friction interface. Furthermore, the portions of the bearing housing 148 located between the knurls may have smaller diameters, in some cases equal to or less than the bore diameter of the engagement portion 145a, and therefore less force may be needed during the press fitting process and the risk of damaging the impeller 140 may be reduced, as compared to if the bearing housing 149 had a uniform diameter which exceeded the bore diameter of the engagement portion 145a. In some examples, the knurls 170 may have a barbed configuration in which they have a sloped lead-in surface followed by a cutback (notch). The sloped lead-in surface makes it easier to insert the bearing housing 149 in the forward direction into the bore of the engagement portion 145a, whereas the cutback provides a relatively sharp trailing edge which can bite into the inner surface of the engagement portion 145a and thereby strongly resist rearward retraction of the bearing housing 149 from the impeller 140. In some examples, the knurls 170 are arranged in one or more layers, and in instances where there are multiple of these layer, they may be stacked atop one another in the axial direction. In some examples, within each layer, the knurls 170 of that layer are evenly distributed around a perimeter of the bearing housing 149. In some examples, the portions of the bearing housing 149 which extend between adjacent knurls 170 include a straight segment such that the knurls and the straight segments together from a shape having a profile of a polygon with the knurls 170 disposed at the corners or points of the polygon. For example, in some implementations each layer of knurls 170 may include six knurls 170 arranged evenly around the perimeter and these, together with the straight segments extending therebetween, form a shape having a profile of, approximately, a hexagon. In some examples, there are fewer knurls 170 per layer (e.g., three, four, five, etc.) and in other examples there are more knurls 170 per layer (e.g., seven, eight, etc.). In some examples, each layer has the same number of knurls 170 as the others. In other examples, the number of knurls 170 per layer may vary from one layer to another. In some examples, the knurls 170 of each layer are aligned axially with the knurls 170 of the other layers. In other examples, one or more of the knurls 170 of one layer is not aligned with a knurl of another layer. In some examples, each knurl 170 is shaped and sized similarly to the other knurls 170, while in other examples the knurls 170 may have differing or irregular shapes/sizes, whether within a layer or between layers. In some examples, there are two layers of knurls 170 axially stacked. In other examples, there is one layer, in other examples there are three or more layers.

Note that "press-fit" and similar/derivative phrases used herein refer broadly to any of various techniques for mechanically attaching together two parts which have an interference fit by the application of force to press one of the two parts into a cavity of the other part, resulting in a friction attachment therebetween. These techniques which are examples of "press-fitting" as used herein may include cold press-fitting, hot-press fitting, ultrasonic staking, or other techniques. While the application of force to press the parts together is a defining characteristic of a "press-fit" as used herein, pressing need not be the only mechanism which is operative to join the parts together. For example, in some instances heat may be applied to one or both parts (e.g., to the impeller 140) prior to or during the pressing to cause the part to soften and/or to temporarily expand in size. As another example, vibrations (e.g., ultrasonic vibrations, in some cases) may be applied to the parts during or after the pressing, which is also referred to as ultrasonic staking.

As shown in FIG. 1, the shaft 143 is secured to the conduit 130 and housing 110 via a front support 144 and a rear support 151. The front support 144 engages and holds a front portion of the shaft 143 and is coupled to the walls of the conduit 130. The rear support 151 engages and holds a rear portion of the shaft 143 and is also coupled to the walls of the conduit 130. Front and rear are used herein in relation to the orientation of the pump 100 illustrated in FIG. 1, with the inlet side being the "front" side and the outlet side being the "rear" side. However, these terms are meant merely to aid understanding and are not limiting. In particular, in some examples of the pump 100, the supports 144 and 151 could be reversed in orientation, with the support 144 being nearer the outlet 132 and the support 151 being nearer the inlet 131, in which case the terms "front" and "rear" as used herein would be reversed in relation to these components.

In some examples, the pump 100 further comprises an adjustment mechanism 136. The adjustment mechanism 136 couples the shaft 143 to the rear support 151. The adjustment mechanism 136 is actuatable, and when actuated changes the position of the shaft 143 relative to the rear support 151, and hence also relative to the impeller chamber 133. More specifically, the adjustment mechanism 136 is configured to cause translation along the rotation axis 139 of the rear end of the shaft 143 relative to the rear support 151, which in turn causes translation of the front end of the shaft 143 relative to the front support 144. Because the shaft 143 is coupled to the rotor 132 and the rotor 132 is coupled to the impeller 140, when the shaft 143 is translated along the axis 139 this also causes the impeller 140 to be translated along the axis 139 relative to conduit 130. Adjusting the position of the impeller 140 in this manner can change the clearance between the blades 141 and the walls of the conduit 130, particularly near the front end of the impeller 140. This can allow for smaller clearances to be obtained between the blades 141 and conduit 130, which improves performance, without requiring high precision in the parts which would inordinately increase costs. The adjustment mechanism 136 may include, in some examples, any of the adjustment mechanisms described in US Patent Application No. 17/977,200 entitled "AXIAL PUMP WITH ADJUSTABLE IMPELLER" and filed on October 31 2022, the entire contents of which is incorporated herein by reference.

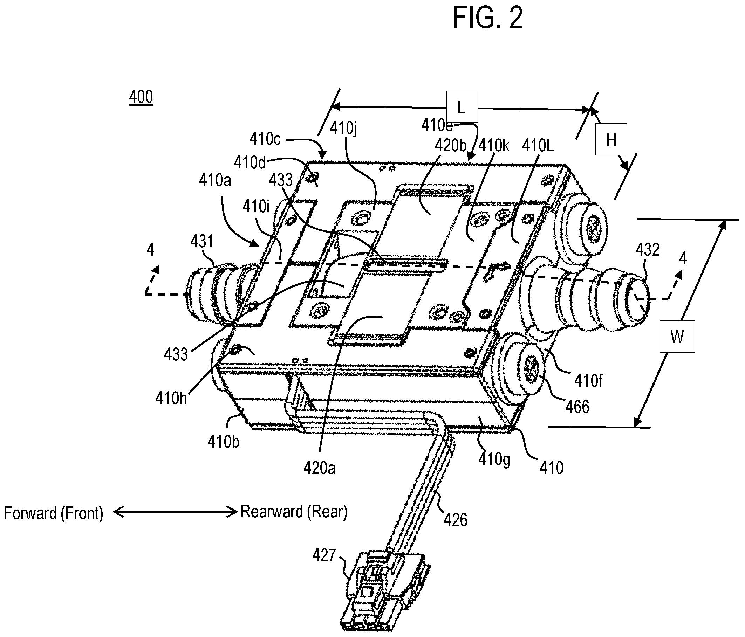

Turning now to FIGs. 2-17, another example pump will be described, in the form of pump 400. The pump 400 is an example configuration of the pump 100 described above. Thus, some components of the pump 400 are similar to (e.g., example configurations of) corresponding components already described above, and thus the descriptions of the components of the pump 100 above are applicable to the similar components of the pump 400, and duplicative descriptions of certain aspects of the pump 400 may thus be omitted. Corresponding components may be referred to using reference numbers having the same last two digits, such as 110 and 410. It should be understood that the pump 400 is but one possible configuration of the pump 100, and the pump 100 is not limited to the pump 400. Similarly, the individual components of the pump 400 are examples of the corresponding individual components of the pump 100, but the individual components of the pump 100 are not limited to the corresponding components of the pump 400.

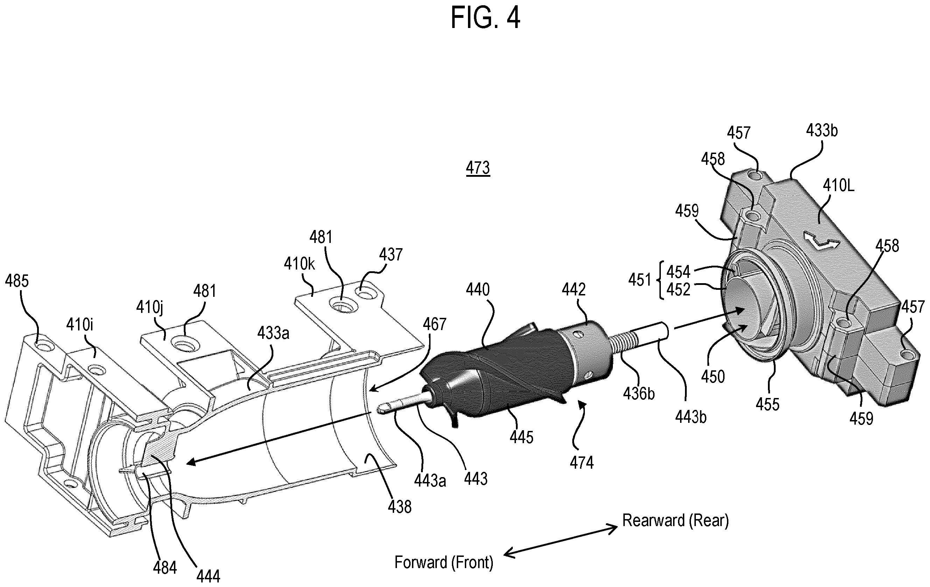

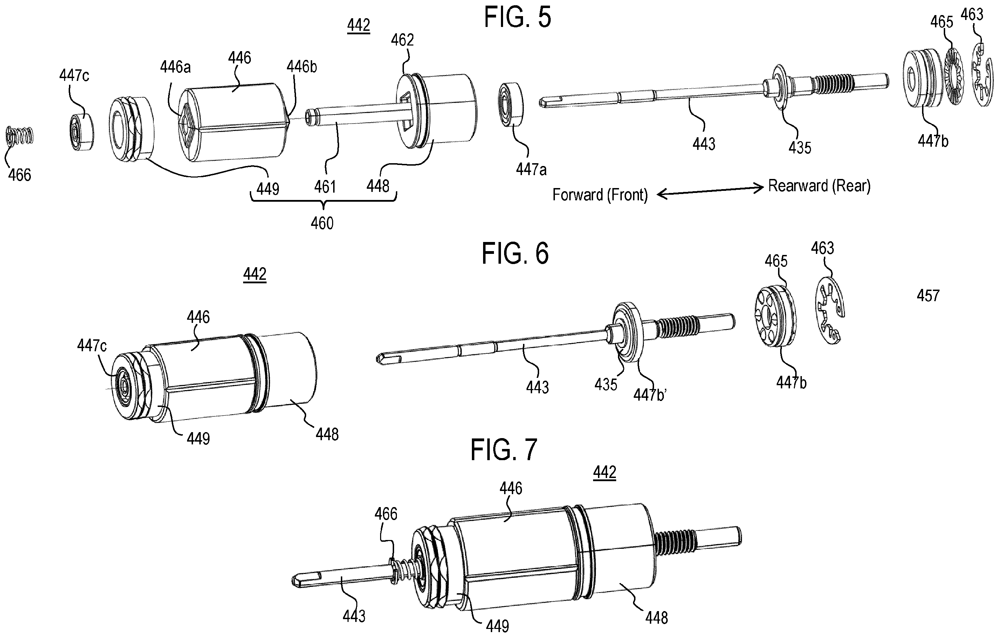

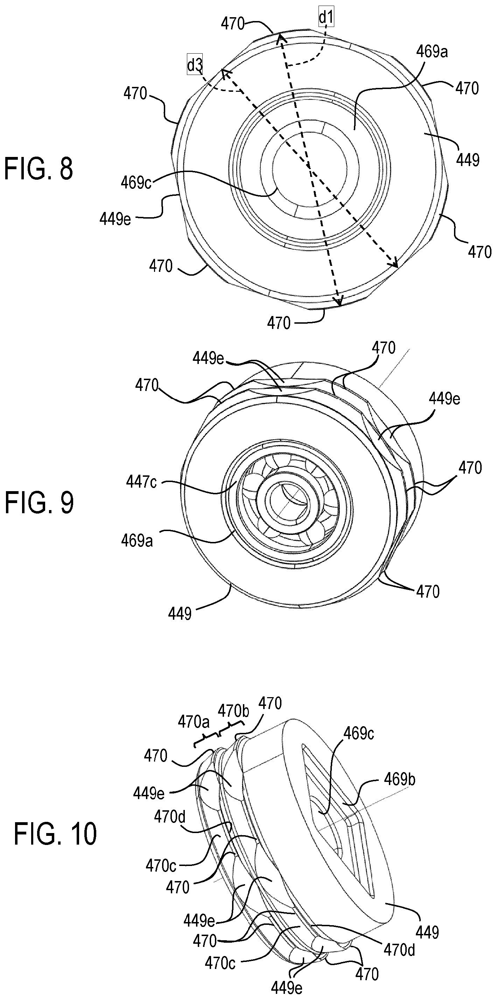

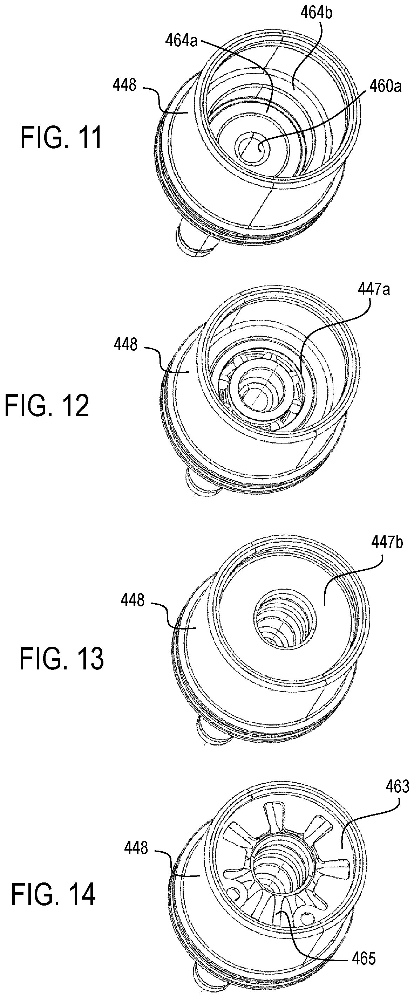

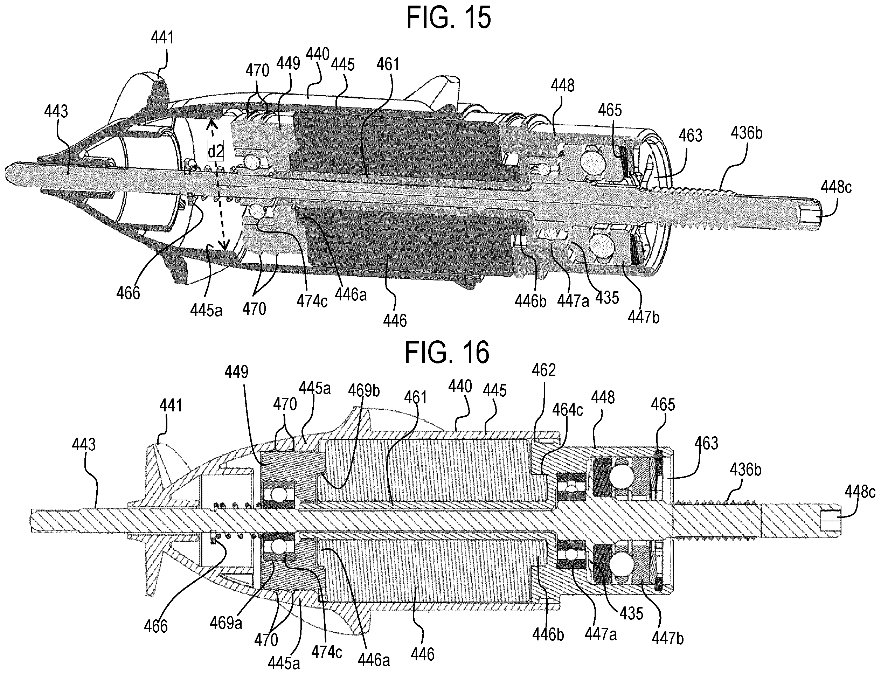

Various aspects of the pump 400 are visible in multiple figures, and different figures may show certain aspects better than others. Thus, rather than describing each of FIGs. 2-17 below in strict sequence, the various aspects of the pump 400 will be described in turn below with reference to some of the figures that are most relevant to the particular aspect under discussion. FIGs. 2, 3, and 17 show views of the full pump 400, including perspective, exploded, and cross-sectional views, respectively. FIGs. 4-16 show isolated portions of the pump 400 in various views: FIG. 4 shows an impeller chamber subassembly 473 of the pump 400 in an exploded and partial cross-sectional view; FIGs. 5-7 show a rotor 442 and shaft 443 of the pump 400 in exploded and perspective views in various states of assembly; FIGs. 8-10 show a front bearing housing 449 of the rotor 442 in various states of assembly; FIGs. 11-14 show a rear bearing housing 448 of the rotor 442 in various states of assembly; and FIGs. 15 and 16 show cross-sections of an impeller/rotor subassembly 474 in partially and fully assembled states.

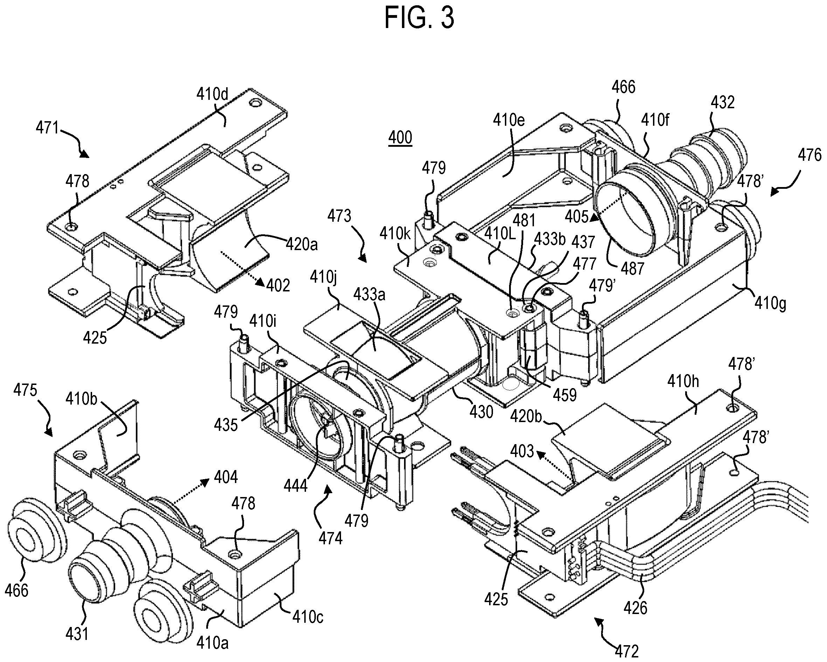

As shown in FIGs. 2 and 3, the pump 400 comprises a number of subassemblies, including a first stator subassembly 471, a second stator subassembly 472, an impeller chamber subassembly 473, an inlet subassembly 475, and an outlet subassembly 476. Each of these subassemblies will be described in greater detail below.

As shown in FIGs. 2 and 3 the first and second stator subassemblies 471 and 472 comprise first and second stator portions 420a and 420b, respectively. In addition, the first and second stator subassemblies 471 and 472 comprise the PCBs 425, which make up a split PCA, such as the split PCA described in the US Patent Application No. 17/976,406 entitled "AXIAL PUMP WITH SPLIT PRINTED CIRCUIT BOARD ASSEMBLY (PCA)" and filed on October 28 2022, the entire contents of which is incorporated herein by reference. The PCBs 425 are electrically coupled, for example via solder or other electrical connections to the first and second stator portions 420a and 420b, respectively. As shown in FIG. 3, the first and second stator subassemblies 471 and 472 are positioned on opposite lateral sides of the impeller chamber subassembly 473. Thus, during assembly of the pump 400 the first and second stator subassemblies 471 and 472 may be positioned as shown in the exploded view of FIG. 3 and then the stator subassemblies 471 and 472 may be moved laterally (along directions indicated by arrows 402 and 403) to bring the stator subassemblies 471 and 472 together around the impeller chamber subassembly 473. Once so assembled, the stator portions 420a and 420b are positioned adjacent to and radially surround the impeller chamber 433 (except for small regions at the top and bottom of the impeller chamber 433, which are not surrounded), as shown in FIG. 2. Moreover, as the first and second stator subassemblies 471 are coupled to the impeller chamber subassembly 473, the PCBs 425 become electrically coupled.

As shown in FIGs. 3 and 4, the impeller chamber subassembly 473 comprises an impeller chamber 433 and an impeller/rotor subassembly 474 housed (at least partially) within the impeller chamber 433. The impeller chamber 433 comprises a front portion 433a and a rear portion 433b.The impeller chamber front portion 433a comprises a bore 467 and the rear portion 433b comprises a bore 450. As suggested by the arrows in FIG. 4 when the impeller chamber subassembly 473 is assembled the front portion 433a and rear portion 444b are coupled together with the impeller/rotor subassembly 474 positioned partially inside the bore 467 and partially inside the bore 450. As shown in FIG. 3, the impeller chamber front portion 433a comprises engagement portion 438, which defines a rear opening of the bore 467. As shown in FIG. 6, the impeller chamber rear portion 433b comprises an engagement portion 455 configured to engage with (e.g., be received within) the engagement portion 438 of the front portion 433a to couple the front portion 433a and rear portion 433b together. The engagement portion 455 encircles and defines the bore 450.

As shown in FIG. 4, the impeller/rotor subassembly 474 comprises an impeller 440 coupled to a rotor 442, which is in turn coupled to a shaft 443. The impeller 440 comprises an impeller body 445, blades 441 protruding radially from the impeller body 445 and spiraling axially and circumferentially along and around the outer surface of impeller body 445. The shaft 443 comprises a front end 443a and a rear end 443b.

As shown in FIG. 5-7, the rotor 442 comprises a bearing tower 460 which includes a bearing tower shaft 461, a front bearing housing 449 attached to a front end of the bearing tower shaft 461, and a rear bearing housing 448 attached to a rear end of the bearing tower shaft 461. The rotor 442 also comprises magnets 446 which are distributed around the tower shaft 461 and fixedly coupled to the bearing tower 460 so as to move together with the bearing tower 460. In this example, the rear bearing housing 448 is integrally connected to the bearing tower shaft 461, whereas the front bearing housing 449 is initially separate from the bearing tower shaft 461 and is subsequently attached thereto, for example via adhesives or other fasteners, but in other examples either bearing housing could be formed separately from the tower shaft 461 and be later attached thereto. The bearing housings 448 and 449 each house bearings 447 that rotatably coupled the rotor 442 to the shaft 443. Specifically, as shown in FIGs. 5-16, the front bearing housing 449 contains front radial bearings 447a, whereas the rear bearing housing 448 contains rear radial bearings 447b and rear thrust bearings 447c.

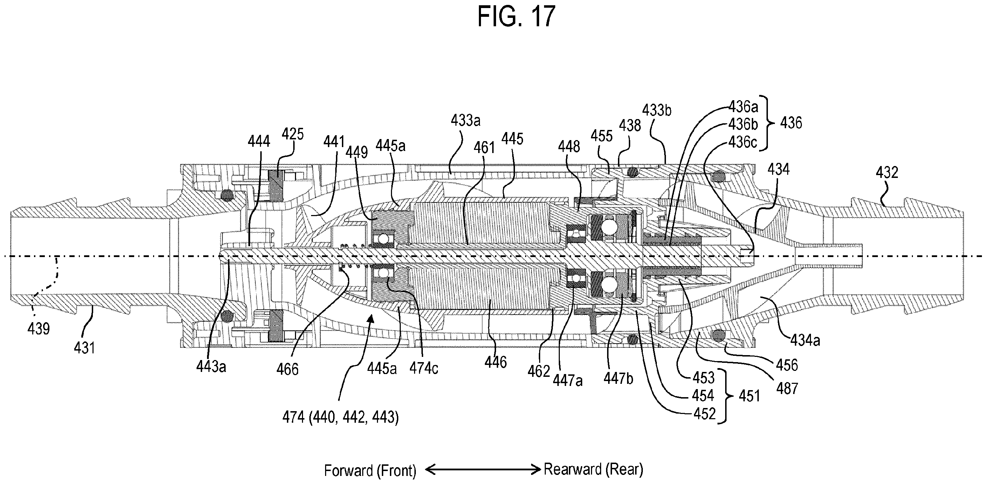

As shown in FIG. 8, a front end of the front bearing housing 449 has a cavity 469a, and as shown in FIG. 9 the front radial bearings 447c are disposed in this cavity 469a. As shown in FIG. 11, the rear bearing housing 448 has a first cavity 464a, and as shown in FIG. 12 the rear radial bearings 447a are disposed in this first cavity 464a. As shown in FIG. 11, the rear bearing housing 448 has a second cavity 464b, and as shown in FIG. 13 the rear thrust bearings 447b are disposed in this second cavity 464b behind the rear radial bearings 447a. As shown in FIGs. 5 and 17, the shaft 443 comprises a flange 435 which is disposed between the rear radial bearings 447a and the rear thrust bearings 447b, with the thrust bearings 447b bearing axially against the flange 435.

The rotor 442 is assembled in the following manner. As shown in FIG. 6, the magnets 446 are positioned on the bearing tower 460 around the tower shaft 461, and then the front bearing housing 449 is attached to the front end of the tower shaft 461 to secure the magnets 446 in place. The presence of the front bearing housing 449 on one side of the magnets 446 and the rear bearing housing 448 disposed on the opposite side thereof keeps the magnets 446 from moving axially off the tower shaft 461. In some examples, the magnets 446 are attached together as a unit, for example by magnetic attraction, adhesive, welding/solder, and/or mechanical fasteners (not illustrated). In some examples, the magnets may also be more affirmatively attached to the bearing tower 460, for example by the application of adhesives, mechanical fasteners, etc.

Furthermore, in some examples, the front and rear bearing housings 449 and 448 not only block the magnets 446 from moving axially off the shaft 461 but also engage with and hold the magnets 446 so as to prevent them moving radially off the shaft 461. For example, as shown in FIG. 10, a rear end of the front bearing housing 449 may have a cavity 469b which is configured to receive a protruding portion 446a of magnets 446 (see FIG. 5) to aid in securing magnets 446 to bearing tower 460. Similarly, as shown in FIG. 5, rear bearing housing 449 also has a cavity 464c which is configured to engage with a protruding portion 446b protruding from the other end of the magnets 446 to aid in securing the magnets 446 to the bearing tower 460.

After the magnets 446 have been assembled on the bearing tower 460, the front radial bearings 447c may be inserted into the cavity 496a of the front bearing housing 449, as shown in FIG. 9. The rear radial bearings 447a may also be inserted into the first cavity 464a of the rear bearing housing 448, as shown in FIG 12 (this could be done before or after assembly of the magnets 446 to the bearing tower 460). In addition, as shown in FIG. 6, an inner race 447b' of the thrust bearing 447b may be assembled onto the shaft 443, in some examples, by press-fitting.

Next, the front end of the shaft 443 may be inserted through an interior bore 460a of the bearing tower 460. The bore 460a passes axially through the center of the shaft 461 (see FIG. 11) and is aligned with bore 469c of the front bearing housing 449 (see FIG. 8). During this insertion, the shaft 443 also passes through the bore 469c of the front bearing housing 449 and through central openings in the front and rear radial bearings 447a and 447c.

Either prior to or after the insertion of the shaft 443, the remainder of the thrust bearing 447b may be inserted onto the rear end of the shaft 443 and into the second cavity 464b of the rear bearing housing 448. Next, a spring clip retainer 463 is then inserted into the rear bearing housing 448 to retain the thrust bearing 447b therein, as shown in FIG. 14. A gasket 465 may be disposed between thrust bearing 447b and retainer 463.

As shown in FIG. 7, a clip and spring retainer 466 may be attached to the shaft 443 forward of the front bearing housing 449. The spring of the retainer 466 applies rearward pressure on the front radial bearings 447c, which helps to hold the front radial bearings 447 in their installed position within the cavity 469a. The use of the spring avoids slop or play due to tolerances stacking up in the rotor 442.

After the above-described processes, the rotor 442 is fully assembled onto the shaft 443, resulting in the state shown in FIG. 7.

Subsequent to the assembly of the rotor 442, the rotor 442 (with the shaft 443 coupled thereto) and the impeller 400 may be assembled together to form the impeller/rotor subassembly 447. This assembly process may proceed as follows.

First, the front of the rotor 442 is inserted into the interior bore of the impeller 440 and advanced forward until the front bearing housing 449 reaches the engagement portion 445a, as shown in FIG. 16. A widest diameter of the rotor 442 may be less than widest diameter of the internal bore of the impeller body 445, and therefore the rotor 442 may be inserted into the bore with relatively little resistance up until the front bearing housing 449 reaches the engagement portion 445a. Once the front bearing housing 449 reaches the engagement portion 445a, the rotor 442 will resist being advanced farther forward because the front bearing housing 449 has a maximum outer diameter which exceeds the inner bore diameter of the engagement portion 445a (i.e., the front bearing housing 449 and the engagement portion 445a have an interference fit).

Next, the impeller 440 and the rotor 442 may be pressed axially together, for example, by a hydraulic press or other press fitting equipment, causing the front bearing housing 449 to be press-fitted into the engagement portion 445a, as shown in FIG. 17.

Returning to FIGs. 8-10, in this example the front bearing housing 449 has twelve knurls 470. These knurls 470 are arranged in two axially stacked layers, a first layer 470a and a second layer 470b, as shown in FIG. 10. Each of these layers include six of the knurls 470 distributed around the perimeter of the front bearing housing 449, as shown in FIG. 8. In other examples, different numbers of knurls 470 may be provided per layer, and/or different numbers of layers may be used. An outer diameter of the front bearing housing 449 between two opposing knurls 470 is d1, as shown in FIG. 8. As shown in FIG. 16, an inner diameter of the engagement portion 445a is d2. Because d2 < d1, the front bearing housing 449 has an interference fit with the engagement portion 445a, and when the two are press-fit together, the knurls 470 engage with and displace portions of the interior surface of the engagement portion 445a, forming a strong mechanical attachment. As shown in FIG. 10, each knurl 470 has a barbed configuration with a sloped lead-in portion 470c and a cutback 470d. The sloped lead-in portion 470c allows for easier insertion into the engagement portion 445a during press-fitting, while the cutback 470d creates a sharp edge which can dig into the engagement protein 445a and resist rearward movement of the front bearing housing 449 relative to the impeller 440.

As shown in FIGs. 8 and 9, there may be flat segments 449e extending between adjacent pairs of the knurls 470. A diameter of the front bearing housing 449 in the regions between the knurls 470, or in other words the distance from one of the flat segments 449e to a diametrically opposite flat segments 449e, is d3. In the illustrated example, d3 is equal to or less than d2. Thus, these portions of the front bearing housing 449 between the knurls 470 may insert relatively easily into the engagement portion 445a. In other words, in some examples, only the knurls 470 interfere with the engagement portion 445a, and therefore the amount of force needed for the press-fitting can be reduced (as compared to if the entire front bearing housing 449 had diameter d2) and the likelihood of damaging the impeller 440 may be reduced. In addition, the strength of the attachment may be stronger with only the knurls 470 having diameter d2, as compared to if the entire front bearing housing 449 had diameter d2. In other examples, d3 is slightly less than d2. In other examples, d3 is slightly more than d2.

Once the impeller/rotor subassembly 474 is assembled, it may be inserted into the conduit 430 and the shaft 443 may be coupled to the conduit 430. Thus, as the impeller 440 rotates about the shaft 443 it also rotates relative to the conduit 430. As shown in FIGs. 4 and 17, when the impeller chamber subassembly 473 is assembled, the impeller 440 is contained within the impeller chamber 433, with a front end 443 of the shaft 443 thereof coupled to the front portion 433a of the impeller chamber 433 and a rear end 443b of the shaft 443 coupled to the rear portion 433b of the impeller chamber 433. More specifically, a front end 443a of the shaft 443 of the impeller 440 is inserted into a hub 484 in a front support 444, as shown FIGs. 17. The front support 444 is coupled to the walls of the impeller chamber 433. Thus, when the front end 443a is engaged by the front support 444, the front support 444 supports the shaft 443 relative to the impeller chamber 433. Similarly, the rear end 443b of the shaft 443 is inserted into and engaged by a rear support 451 of the rear portion 433b of the impeller chamber, as shown in FIGs. 17. In particular, an adjustment mechanism 436 is used to couple the shaft 443 to the rear support 451. The adjustment mechanism 436 comprises a nut 436a, a set screw 436b of the shaft 443, and a socket 436c in the end of the shaft 443. The nut 436a is attached to a nut holding portion 453 of the rear support 451 and receives the set screw 436b such that rotation of the shaft 443 relative to nut 436a causes shaft 443 to translate relative to rear support 451. Socket 436c receives a tool to allow rotation of the shaft 443 in this manner.

As shown in FIGs. 4 and 17, the rear support 451 comprises a cylinder 452 encircling the bore 450, a nut holding portion 453 coupled to one end of the cylinder 452, and attachment portions 454 that extend radially from the cylinder 452 to couple the cylinder 452 to the engagement portion 455. Although not visible in the figures, the attachment portions 454 are arranged so as to not block the flow of liquid through the chamber 433, with the liquid flowing through the space between the engagement portion 455 and the cylinder 452 and around the attachment portions 454.

The impeller chamber 433 is also coupled to various support structures and/or comprises various surfaces that form part of the housing 410 and which facilitate joining of the other subassemblies together. For example, as shown in FIG. 4, the rear portion 433b comprises fastener holders 459 with holes 458 to receive fasteners 477. As shown in FIGs. 3 and 4 the front portion 433a comprises holes 437, and when the front portion 433a and rear portion 433b are coupled together the holes 437 align with the holes 458. Thus, as shown in FIG. 3 a fastener 477 is inserted through the holes 437 and 458 to secures the front portion 433a and rear portion 433b in the coupled state. In addition, as shown in FIG. 4, the rear portion 433b also comprises holes 457, which receive fasteners 479, as shown in FIG. 3. Similarly, the front portion 433a comprises holes 485, as shown in FIG. 4, to receive fasteners 479, as shown in FIG. 3. These fasteners 479 are used to couple the various subassemblies together, as will be described below. In some examples, the front portion 433a may also comprise holes 481, which may be used to fill the pump 400 with epoxy after assembly to make the pump 400 water resistant and also to aid with transfer of heat from pump 400 components into the coolant by removing air gaps. Furthermore, the impeller chamber 433 is coupled to housing portions 410i, 410j, 410k, and 410L.

The inlet subassembly 475 comprises the inlet 431 and vibration isolators 466. The outlet subassembly 476 comprises the outlet 432 and vibration isolators 466. In the illustrated example, the inlet 431 and outlet 432 comprise hose barb couplings. In other examples, other types of liquid couplings may be substituted for the hose barb couplings. The pump 400 may be coupled to another device (e.g., a chassis of a computing device that the pump 400 is disposed within) via the vibration isolators 459. The vibration isolators 459 may be rubber, silicon, or another compliant material that helps to absorb vibrations generated by the pump 400 and prevent (or reduce) the transmission of these vibrations to the device in which the pump 400 is disposed. As shown in FIG. 3, the outlet 432 comprises an engagement portion 487. This engagement portion 487 is configured to engage with an engagement portion 456 of the impeller chamber rear portion 433b, as shown in FIG. 17. As shown in FIG. 17, the outlet 432 may also comprise a outlet guide vane (OGV) 434 which includes fins 434a. The OGV 434 guides the flows of liquid as they exit the impeller chamber 433 and enter the outlet 432. This OGV 434 may help to straighten out the flows, removing or reducing some of the circumferential motion of the liquid flows, which is introduced by the rotation of the impeller 440, so that the fluid moves predominantly or only axially upon exiting outlet 432.

In addition, each of the inlet and outlet subassemblies 475 and 476 comprises portions of the housing 410. As shown in FIG. 3, the inlet and outlet subassemblies 475 and 476 may be positioned on opposite axial sides of the impeller chamber subassembly 473. Thus, during assembly of the pump 400 the inlet and outlet subassemblies 475 and 476 may be positioned as shown in FIG. 3 and then moved towards one another (along directions indicated by arrows 404 and 405) until the inlet 431 is fluidically coupled with one side of the impeller chamber 433 and the outlet 432 is fluidically coupled with the other side of the impeller chamber 433. In some examples, this assembly step may occur after the two stator subassemblies 471 and 472 have been assembled onto the impeller chamber subassembly 473. Once the inlet 431, outlet 432, and impeller chamber 433 are coupled together, they form the conduit 430 through which liquid coolant may flow along a central axis 439 thereof.

As shown in FIGs. 2 and 3, the pump 400 comprises a housing 410. This housing 410 may be made up of multiple portions that are joined together. Specifically, the subassemblies described above may comprise these portions of the housing 410. In particular, the housing 410 comprises inlet end wall portion 410a and lateral wall portions 410b and 410c coupled to inlet end wall portion 410a. These portions 410a-c are part of the inlet subassembly 475. The housing 410 further comprises outlet end wall portion 410f and lateral wall portions 410g and 410e. These portions 410e-g are part of the outlet subassembly 475. When assembled, the aforementioned portions 410a-c and 410e-g define the perimeter side walls of the housing 410. The housing 410 also comprises top portion 410d which is coupled to the first stator portion 420a and part of the first stator subassembly 471, and top portion 410h which is coupled to the second stator portion 420b and part of the second stator subassembly 472. The housing also comprises top housing portions 410i, 410j, 410k, and 410L which are coupled to the conduit 430 and are part of the impeller chamber subassembly 473. The top portions 410d, 410h, and 410i-410L form the top face of the housing 410. Note that the top face of the housing 410 is not necessarily uniform and does not necessarily fully cover all of the pump 400. For example, a top of the stator portion 420a and 420b may be exposed and approximately coplanar with the top face of the housing 410 (this may allow the height dimension of the pump 400 to be reduced to the absolute minimum possible for a given size of stator 420). Some of the housing portions may include holes 478 (only some are labeled) that are arranged to receive a fastener 479 to couple the subassemblies together. For example, in some implementations including the one illustrated in FIG. 3, the impeller chamber subassembly 473 comprises fasteners 479 in the form or pins, such as spring-biased push pins, and each of these may be inserted into holes 478 of one more the subassemblies to secure the respective subassemblies together. A single fastener 479 may be inserted through two holes 478 of two different subassemblies-for example, the fastener labeled 479' in FIG. 3 may be inserted into the two holes labeled 478' which are part of the stator subassembly 472 and the outlet subassembly 476. The other fasteners 479 and holes 478 may be similarly joined.

The bottom portion of the housing 410 (which is generally not visible in the figures and is not labeled herein) may be similarly constructed as the top portion thereof, and thus duplicative description of these portions is omitted.

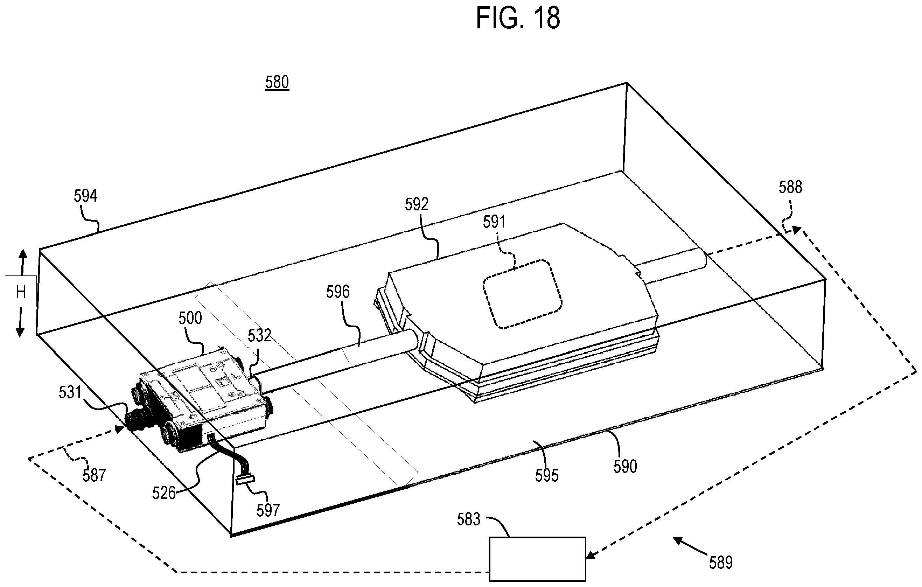

FIG. 18 comprises a schematic diagram illustrating an example system 580 and electronic device 590. The system 580 comprises the electronic device 590 and a liquid cooling loop 589 coupled to the electronic device 590. The system may also comprise additional electronic devices (not illustrated). For example the system 580 may comprise a rack or plurality of racks of electronic devices. The electronic device 590 is illustrated in a state of being installed in the system 580 for convenience of description, but it should be understood that the electronic device 590 may be provided separate from the system 580.

The liquid cooling loop 589 comprises the pump 500 (described below), one or more coolant supply lines 587, one or more coolant return lines 588, and one or more additional cooling loop components 583 such as a heat exchanger, rack-, row-, or datacenter-level coolant distribution unit(s), a chiller, or other cooling components that would be familiar to those of ordinary skill in the art.

The electronic device 590 comprises a PCB 595, such as a baseboard or motherboard of a computing device, and a chassis 594 supporting and housing the PCB 595. The PCB 595 comprises an electrical component 591, such as a processor, power supply unit, memory device, hardware accelerator, or any other electrical component. The electronic device 590 further comprises a cold plate 592 thermally coupled to the electrical component 591.

The electronic device 590 further comprises a pump 500 disposed with in the chassis 594. The pump 500 may be any of the pumps described above, such as the pump 100 and the pump 400. The pump 500 is fluidically coupled with the cold plate 592 via coolant line 596. The pump 500 is electrically connected to the PCB 595 via wires/cable connected to connector 598 of the PCB 595. Thus, the PCB 595 can supply power to and/or communicate with the pump 500. The pump 500 comprises an inlet 531 that may be coupled to the liquid coolant supply line 587 of the liquid cooling loop 589 of the system 580, which supplies liquid coolant to the pump 500. An outlet 532 of the pump 500 is coupled to the coolant line 596. An outlet of the cold plate 592 may be coupled to a liquid coolant return line 588 of the liquid cooling loop, which returns liquid coolant to the remainder of the loop for eventual cooling (e.g., at a heat exchanger). Thus, when the electronic device 590 is installed in the system 580 and fluidically coupled into the liquid cooling loop 589 thereof, liquid coolant from the loop 589 can flow through the pump 500 and cold plate 592. In particular, the pump 500 may be configured to cause (or at least contribute to) the flowing of the liquid coolant through the cold plate 592 to cool the electrical component 591.

Further examples according to the present disclosure are described in the following non-limiting clauses, numbered C1 to C20:
C1. An axial pump for delivering liquid coolant to cool an electronic device, comprising:
   a conduit defining a flow path from an inlet of the conduit to an outlet of the conduit;
   an impeller in the conduit;
   a shaft disposed in and coupled to the conduit;
   a rotor disposed in a hollow interior of the impeller, the rotor comprising magnetic portions, a front bearing housing, and a rear bearing housing, the front and rear bearing housing comprising bearings rotatably coupling the rotor to the shaft, the rotor being coupled to the impeller by a press-fit attachment of the front bearing housing to the impeller;
   a motor stator configured to drive rotation of the rotor about the shaft, the impeller rotating with the rotor about an axis of rotation extending parallel to the flow path.
C2. The axial pump of clause C1,
   wherein the front bearing housing comprises knurls protruding from an outer surface of the front bearing housing.
C3. The axial pump of clause C2,
   wherein the knurls are arranged in two or more layers stacked axially along the outer surface of the front bearing housing.
C4. The axial pump of clause C3,
   wherein each of the layers comprises multiple of the knurls distributed evenly around a perimeter of the front bearing housing.
C5. The axial pump of clause C4,
   wherein each of the layers comprises six of the knurls.
C6. The axial pump of any one of clauses C2 to C5,
   wherein the impeller comprises an engagement portion configured to engage with the front bearing housing, the engagement portion including a bore having an inner bore diameter; and
   wherein the knurls include a pair of knurls disposed diametrically opposite one another and a diameter of the front bearing housing at the pair of knurls exceeds the inner bore diameter of the bore of the engagement portion.
C7. The axial pump of clause C6,
   wherein the front bearing housing includes intermediate portions between adjacent ones of the knurls, and a diameter of the front engagement portion between a pair of the intermediate portions diametrically opposite one another equal to or less than the inner bore diameter of the bore of the engagement portion.
C8. The axial pump of any one of clauses C2 to C7,
   wherein the knurls have a barbed configuration.
C9. The axial pump of any one of clauses C1 to C8,
   wherein the rotor comprises a bearing tower comprising the front bearing housing, the rear bearing housing, and a bearing tower shaft extending between the front bearing housing and the rear bearing housing, the shaft of the pump extending through the bearing tower shaft, the magnet portions coupled to the bearing tower and distributed around the bearing tower shaft.
C10. The axial pump of any one of clauses C1 to C9,
   wherein the bearings include a front radial bearing disposed in the front bearing housing, a rear radial bearing disposed in the rear bearing housing, and a rear thrust bearing disposed in the rear bearing housing.
C11. The axial pump of any one of clauses C1 to C10,
   wherein the rotor is mechanically coupled to the impeller by the press-fit attachment without any bonding agents or adhesives affixing the rotor to the impeller.
C12. The axial pump of any one of clauses C1 to C11,
   wherein the impeller comprises an impeller body and one or more blades protruding radially from and spiraling axially and circumferentially along the impeller body.
C13. An electronic device, comprising:
   a printed circuit board (PCB);
   an electrical component coupled to the PCB;
   a chassis housing the PCB;
   a cold plate thermally coupled to the electrical component; and
   the axial pump of any one of clauses C1 to C12 disposed within the chassis, wherein the conduit of the axial pump is fluidically coupled with the cold plate.
C14. The electronic device of clause C13,
   wherein the electronic device is a server and the electrical component is a processor.
C15. A system, comprising:
   a plurality of information processing devices, each comprising a chassis, a printed circuit board disposed in the chassis, an electrical component coupled to the PCB; and a cold plate thermally coupled to the electrical component;
   a plurality of instances of the axial pump of any one of clauses C1 to C12, wherein each of the axial pumps is disposed in the chassis of one of the information processing devices the conduit of the respective axial pump is fluidically coupled with the cold plate of the respective information processing device;
   a liquid cooling loop comprising liquid coolant supply lines configured to supply liquid coolant to the axial pumps, liquid coolant return lines configured to return liquid coolant from the pumps, and a heat exchanger configured to cool the liquid coolant.
C16. The system of clause C15, comprising:
   wherein the axial pumps are individually controllable to individually adjust the flow rate of the liquid coolant through the information processing devices.
C17. A method of manufacturing an axial pump, comprising:
   providing a rotor comprising the rotor comprising magnetic portions, a front bearing housing, and a rear bearing housing, the front and rear bearing housing comprising bearings to rotatably couple the rotor to a shaft;
   inserting the rotor into a hollow interior of an impeller; and
   press-fitting the front bearing housing into an engagement portion of the impeller by pressing the rotor and the impeller together using press-fitting equipment.
C18. The method of clause C17, wherein the rotor is mechanically attached to the impeller by the press-fitting without the use of bonding agents or adhesives bonding the rotor to the impeller.
C19. The method of clause C17 or C18, further comprising coupling the rotor to the shaft prior to inserting the rotor into a hollow interior of an impeller.
C20. The method of clause C19, comprising:
   inserting an assembly of the impeller, the rotor, and the shaft into an impeller chamber;
   inserting a first end of a shaft of the impeller into a hub of a first support coupled to the impeller chamber;
   coupling a second end of the shaft to a second support coupled to the impeller chamber;
   positioning a first stator subassembly on a first lateral side of the impeller chamber and a second stator subassembly on a second lateral side of the impeller chamber, the first and second stator subassemblies comprising two portions of a motor stator configured to drive rotation of the impeller;
   assembling the first and second stator subassemblies and the impeller chamber by moving the first and second stator subassemblies towards the impeller chamber such that the impeller chamber is captured between the first and second stator subassemblies; and
   coupling a pump inlet structure to one end of the impeller chamber and coupling an pump outlet structure to an opposite end of the impeller chamber, the pump inlet structure, pump outlet structure, and impeller chamber forming a conduit defining a flow path of the axial pump.

It is to be understood that both the general description and the detailed description provide examples that are explanatory in nature and are intended to provide an understanding of the present disclosure without limiting the scope of the present disclosure. Various mechanical, compositional, structural, electronic, and operational changes may be made without departing from the scope of this description and the claims. In some instances, well-known circuits, structures, and techniques have not been shown or described in detail in order not to obscure the examples. Like numbers in two or more figures represent the same or similar elements.

In addition, the singular forms "a", "an", and "the" are intended to include the plural forms as well, unless the context indicates otherwise. Moreover, the terms "comprises", "comprising", "includes", and the like specify the presence of stated features, steps, operations, elements, and/or components but do not preclude the presence or addition of one or more other features, steps, operations, elements, components, and/or groups. Components described as coupled may be electronically or mechanically directly coupled, or they may be indirectly coupled via one or more intermediate components, unless specifically noted otherwise. Mathematical and geometric terms are not necessarily intended to be used in accordance with their strict definitions unless the context of the description indicates otherwise, because a person having ordinary skill in the art would understand that, for example, a substantially similar element that functions in a substantially similar way could easily fall within the scope of a descriptive term even though the term also has a strict definition.

And/or: Occasionally the phrase "and/or" is used herein in conjunction with a list of items. This phrase means that any combination of items in the list-from a single item to all of the items and any permutation in between-may be included. Thus, for example, "A, B, and/or C" means "one of {A}, {B}, {C}, {A, B}, {A, C}, {C, B}, and {A, C, B}".

Elements and their associated aspects that are described in detail with reference to one example may, whenever practical, be included in other examples in which they are not specifically shown or described. For example, if an element is described in detail with reference to one example and is not described with reference to a second example, the element may nevertheless be claimed as included in the second example.

Unless otherwise noted herein or implied by the context, when terms of approximation such as "substantially," "approximately," "about," "around," "roughly," and the like, are used, this should be understood as meaning that mathematical exactitude is not required and that instead a range of variation is being referred to that includes but is not strictly limited to the stated value, property, or relationship. In particular, in addition to any ranges explicitly stated herein (if any), the range of variation implied by the usage of such a term of approximation includes at least any inconsequential variations and also those variations that are typical in the relevant art for the type of item in question due to manufacturing or other tolerances. In any case, the range of variation may include at least values that are within ±1% of the stated value, property, or relationship unless indicated otherwise.

Further modifications and alternative examples will be apparent to those of ordinary skill in the art in view of the disclosure herein. For example, the devices and methods may include additional components or steps that were omitted from the diagrams and description for clarity of operation. Accordingly, this description is to be construed as illustrative only and is for the purpose of teaching those skilled in the art the general manner of carrying out the present teachings. It is to be understood that the various examples shown and described herein are to be taken as exemplary. Elements and materials, and arrangements of those elements and materials, may be substituted for those illustrated and described herein, parts and processes may be reversed, and certain features of the present teachings may be utilized independently, all as would be apparent to one skilled in the art after having the benefit of the description herein. Changes may be made in the elements described herein without departing from the scope of the present teachings and following claims.

It is to be understood that the particular examples set forth herein are non-limiting, and modifications to structure, dimensions, materials, and methodologies may be made without departing from the scope of the present teachings.

Other examples in accordance with the present disclosure will be apparent to those skilled in the art from consideration of the specification and practice of the invention disclosed herein. It is intended that the specification and examples be considered as exemplary only, with the following claims being entitled to their fullest breadth, including equivalents, under the applicable law.

## Claims

1. An axial pump for delivering liquid coolant to cool an electronic device, comprising:
a conduit defining a flow path from an inlet of the conduit to an outlet of the conduit;
an impeller in the conduit;
a shaft disposed in and coupled to the conduit;
a rotor disposed in a hollow interior of the impeller, the rotor comprising magnetic portions, a front bearing housing, and a rear bearing housing, the front and rear bearing housing comprising bearings rotatably coupling the rotor to the shaft, the rotor being coupled to the impeller by a press-fit attachment of the front bearing housing to the impeller;
a motor stator configured to drive rotation of the rotor about the shaft, the impeller rotating with the rotor about an axis of rotation extending parallel to the flow path.

2. The axial pump of claim 1,
wherein the front bearing housing comprises knurls protruding from an outer surface of the front bearing housing.

3. The axial pump of claim 2,
wherein the knurls are arranged in two or more layers stacked axially along the outer surface of the front bearing housing, optionally:
wherein each of the layers comprises multiple of the knurls distributed evenly around a perimeter of the front bearing housing; and/or:
wherein each of the layers comprises six of the knurls; and/or
wherein the knurls have a barbed configuration.

4. The axial pump of claim 2 or 3,
wherein the impeller comprises an engagement portion configured to engage with the front bearing housing, the engagement portion including a bore having an inner bore diameter; and
wherein the knurls include a pair of knurls disposed diametrically opposite one another and a diameter of the front bearing housing at the pair of knurls exceeds the inner bore diameter of the bore of the engagement portion.

5. The axial pump of claim 4,
wherein the front bearing housing includes intermediate portions between adjacent ones of the knurls, and a diameter of the front engagement portion between a pair of the intermediate portions diametrically opposite one another equal to or less than the inner bore diameter of the bore of the engagement portion.

6. The axial pump of any one of the preceding claims,
wherein the rotor comprises a bearing tower comprising the front bearing housing, the rear bearing housing, and a bearing tower shaft extending between the front bearing housing and the rear bearing housing, the shaft of the pump extending through the bearing tower shaft, the magnet portions coupled to the bearing tower and distributed around the bearing tower shaft.

7. The axial pump of any one of the preceding claims,
wherein the bearings include a front radial bearing disposed in the front bearing housing, a rear radial bearing disposed in the rear bearing housing, and a rear thrust bearing disposed in the rear bearing housing; and/or
wherein the rotor is mechanically coupled to the impeller by the press-fit attachment without any bonding agents or adhesives affixing the rotor to the impeller; and/or
wherein the impeller comprises an impeller body and one or more blades protruding radially from and spiraling axially and circumferentially along the impeller body.

8. An electronic device, comprising:
a printed circuit board (PCB);
an electrical component coupled to the PCB;
a chassis housing the PCB;
a cold plate thermally coupled to the electrical component; and
the axial pump of any one of the preceding claims disposed within the chassis, wherein the conduit of the axial pump is fluidically coupled with the cold plate.

9. The electronic device of claim 8,
wherein the electronic device is a server and the electrical component is a processor.

10. A system, comprising:
a plurality of information processing devices, each comprising a chassis, a printed circuit board disposed in the chassis, an electrical component coupled to the PCB; and a cold plate thermally coupled to the electrical component;
a plurality of instances of the axial pump of any one of claims 1 to 7, wherein each of the axial pumps is disposed in the chassis of one of the information processing devices the conduit of the respective axial pump is fluidically coupled with the cold plate of the respective information processing device;
a liquid cooling loop comprising liquid coolant supply lines configured to supply liquid coolant to the axial pumps, liquid coolant return lines configured to return liquid coolant from the pumps, and a heat exchanger configured to cool the liquid coolant.

11. The system of claim 10, comprising:
wherein the axial pumps are individually controllable to individually adjust the flow rate of the liquid coolant through the information processing devices.

12. A method of manufacturing an axial pump, comprising:
providing a rotor comprising the rotor comprising magnetic portions, a front bearing housing, and a rear bearing housing, the front and rear bearing housing comprising bearings to rotatably couple the rotor to a shaft;
inserting the rotor into a hollow interior of an impeller; and
press-fitting the front bearing housing into an engagement portion of the impeller by pressing the rotor and the impeller together using press-fitting equipment.

13. The method of claim 12, wherein the rotor is mechanically attached to the impeller by the press-fitting without the use of bonding agents or adhesives bonding the rotor to the impeller.

14. The method of claim 12 or 13, further comprising coupling the rotor to the shaft prior to inserting the rotor into a hollow interior of an impeller.

15. The method of claim 14, comprising:
inserting an assembly of the impeller, the rotor, and the shaft into an impeller chamber;
inserting a first end of a shaft of the impeller into a hub of a first support coupled to the impeller chamber;
coupling a second end of the shaft to a second support coupled to the impeller chamber;
positioning a first stator subassembly on a first lateral side of the impeller chamber and a second stator subassembly on a second lateral side of the impeller chamber, the first and second stator subassemblies comprising two portions of a motor stator configured to drive rotation of the impeller;
assembling the first and second stator subassemblies and the impeller chamber by moving the first and second stator subassemblies towards the impeller chamber such that the impeller chamber is captured between the first and second stator subassemblies; and
coupling a pump inlet structure to one end of the impeller chamber and coupling an pump outlet structure to an opposite end of the impeller chamber, the pump inlet structure, pump outlet structure, and impeller chamber forming a conduit defining a flow path of the axial pump.
